**Europäisches Patentamt**

**European Patent Office**

**Office européen des brevets**

(19)

(11) Veröffentlichungsnummer: **0 199 990**

**B1**

(12) **EUROPÄISCHE PATENTSCHRIFT**

(45) Veröffentlichungstag der Patentschrift: **13.06.90**

(51) Int. Cl.⁵: **H 03 K 5/05**

(21) Anmeldenummer: **86104102.8**

(22) Anmeldetag: **25.03.86**

(54) **Schaltungsanordnung zur Erzeugung eines Impulses bestimmter Dauer.**

(30) Priorität: **30.03.85 DE 3511842**

(43) Veröffentlichungstag der Anmeldung:
**05.11.86 Patentblatt 86/45**

(45) Bekanntmachung des Hinweises auf die
Patenterteilung:
**13.06.90 Patentblatt 90/24**

(84) Benannte Vertragsstaaten:
**BE DE FR GB IT NL**

(56) Entgegenhaltungen:
**DE-A-3 310 461**
**DE-A-3 325 646**

**HEWLETT-PACKARD JOURNAL, Band 34, Nr. 6,
Juni 1983, Seiten 33-38, Amstelveen, NL; C.
HENTSCHEL et al.: "Designing bipolar
integRated circuits for a pulse/function
generator family"**

(73) Patentinhaber: **Deutsche Thomson-Brandt
GmbH
Hermann-Schwer-Strasse 3 Postfach 1307
D-7730 Villingen-Schwenningen (DE)**

(72) Erfinder: **Rufray, Jean-Claude
Hans-Thoma-Strasse 6
D-7734 Brigachtal (DE)**

## Beschreibung

Die Erfindung geht aus von einer Schaltungsanordnung zur Erzeugung eines durch einen Triggerimpuls ausgelösten Impulses bestimmter Dauer.

Zur Erzeugung eines Impulses konstanter Dauer sind z.B. monostabile Kippstufen bekannt, die durch einen Triggerimpuls in eine einen Ausgangsimpuls liefernde Lage gekippt werden, wonach sie automatisch nach einer durch ein RC-Glied bemessenen Zeit wieder in ihre Ausgangslage zurückkippen. Derartige Kippschaltungen liefern jedoch nur eine im Rahmen der Bauteiletoleranzen des Zeitkonstantengliedes liegende Impulsdauer. Werden genau definierte Impulslängen gefordert, sind derartige Kippschaltungen nicht geeignet. Es sind auch Zeitkonstantenmeßgeräte bekannt, mit denen man die Zeitkonstanten von RC-Gliedern ermitteln kann. Diese besitzen einen Oszillator, der bei Verwendung eines Quarzes sehr genau sein kann. Eine bistabile Kippstufe, die durch den Triggerimpuls gesetzt wird und den Beginn des zu erzeugenden Impulses festlegt, legt gleichzeitig die Schwingungen des Oszillators an den Eingang eines Zählers, der nach einer vorgegebenen Anzahl von Impulsen die bistabile Kippschaltung wieder zurücksetzt, wodurch das Ende des zu erzeugenden Impulses festgelegt ist. Diese Schaltung besitzt zwar den Vorzug großer Genauigkeit ist jedoch mit dem Nachteil verbunden, daß der Triggerimpuls synchron mit den Oszillatorschwingungen sein muß, um eine genaues Zählergebnis zu erhalten.

Es sind bereits verschiedene Schaltungen bekannt, um mit Hilfe eines Triggerimpulses einen Impuls bestimmter Dauer auszulösen (DE—A—33 10 461, Hewlett-Packard Journal, Band 34, Nr. 6, Juni 1983, Seiten 33—38 und DE—A—33 25 646). Dafür wird eine erste Konstantstromquelle bei Eintreffen des Triggerimpulses über eine bistabile Kippstufe zur Aufladung eine Kondensators eingeschaltet. Eine zweite Konstantstromquelle ist zur Entladung des Kondensators vorgesehen Lade- und Entladestromquellen bestimmen die Dauer des erzeugten Impulses.

Der Erfindung liegt die Aufgabe zugrunde, eine Schaltungsanordnung anzugeben, mit welcher ein Impuls bestimmter Dauer erzeugt wird, ohne daß eine aufwendige Synchronisation auf die Schwingungen eines Oszillators erfolgen muß. Die Erfindung besitzt den Vorteil, daß die Erzeugung des Impulses bestimmter Dauer von der Phasenbeziehung zwischen Oszillatorsignal und Triggerimpuls unabhängig ist, so daß der Beginn des zu erzeugenden Impulses allein vom Triggerimpuls bestimmt wird. Ein derartiger Impuls bestimmter Dauer Wird z.B. Zur Ansteuerung des Zeilenendtransistors in Fernsehgeräten benötigt. Er findet auch Anwendung in Schaltungen zur genauen Ermittlung einer Frequenz.

Nachstehend wird das Prinzip der Erfindung an einem Ausführungsbeispiel mit Hilfe der Zeichnung erläutert.

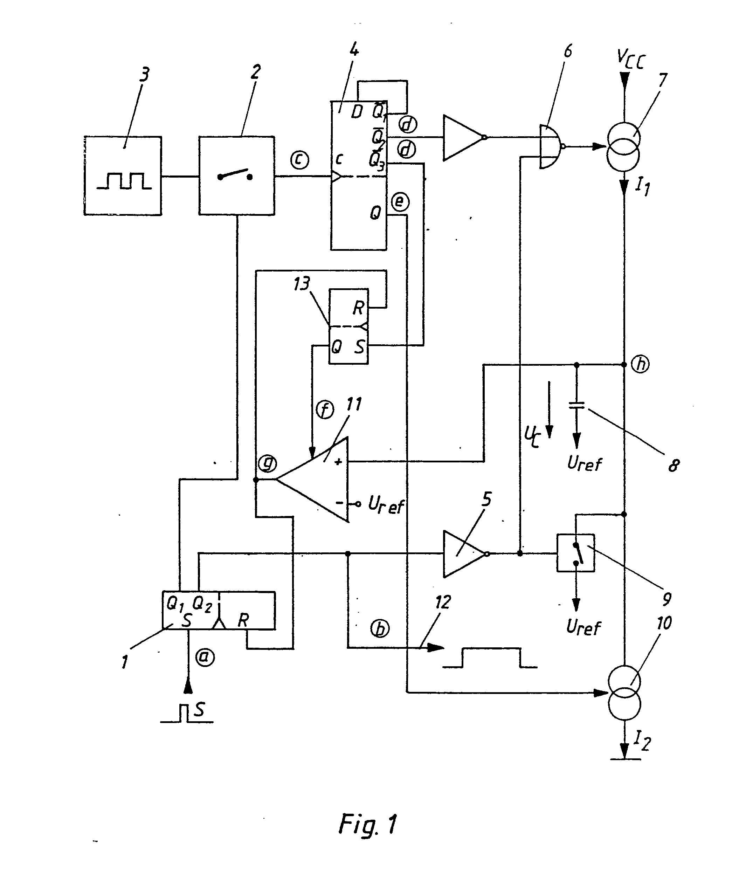

Figur 1 zeigt eine Schaltung zur Erzeugung eines Impulses definierter Länge;

Figur 2 zeigt Diagramme zur Erläuterung der Wirkungsweise der Schaltung nach Figur 1.

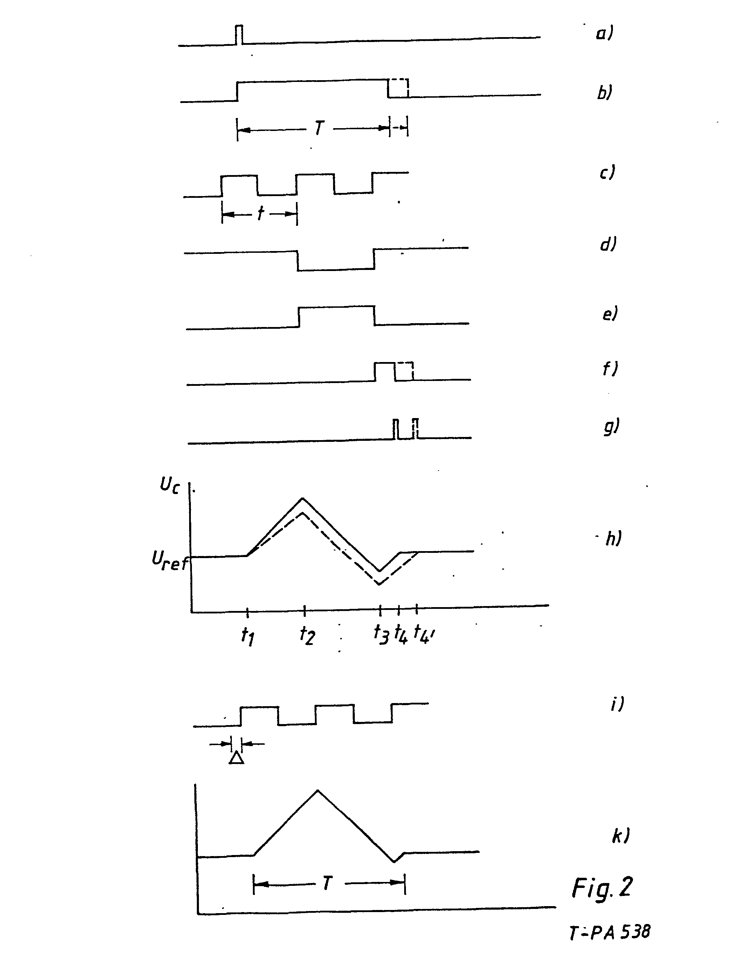

Zu Beginn wird durch einen Triggerimpuls S (Figur 2a) eine bistabile Kippstufe 1 gesetzt, so daß an den Ausgängen Q1 und Q2 H-Potential entsteht (Figur 2b). Der Ausgang Q1 schaltet eine Torschaltung 2 durch, so daß die von einem Impulsgenerator 3 erzeugten Impulse an den Clock-Eingang C eines Frequenzteilers 4 gelangen können. Der Ausgang Q2 der bistabilen Kippschaltung 1, an welchem das gewünschte Impulssignal definierter Länge entnehmbar ist, schaltet über einen Inverter 5 und ein NOR-Gatter 6 eine Konstantstromquelle 7 ein, welche einen Kondensator 8 mit dem Strom I1 während der Zeit von t1 bis t2 von einer Referenzspannung $U_{ref}$ ausgehend auflädt (Figur 2h). Zu Beginn der Ladung wird ein Schaltkontakt 9 geöffnet. Am Kondensator 8 baut sich eine Spannung UC auf (Figur 2h), bei Eintreffen des ersten Impulses aus dem Impulsgenerator 3 geht der Q-Ausgang des Teilers 4 auf H-Potential (Figur 2e) und schaltet die Konstantstromquelle 10 ein, die den Kondensator 8 mit dem Strom I2 von t2 bis t3 (Figur 2h) entlädt. Die erste Konstantstromquelle 7 ist jetzt abgeschaltet. Nach der Dauer t einer Periode des Impulsgenerators 3 wird die zweite Konstantstromquelle 10 ab- und die erste Konstantstromquelle 7 wieder eingeschaltet. Es fließt wieder der Ladestrom I1 von t3 bis t4 und die Spannung UC steigt an bis die Referenzspannung $U_{ref}$ erreicht ist. Die am Kondensator 8 liegende Spannung UC wird mit Hilfe einer Komparatorschaltung 11 mit der Referenzspannung $U_{ref}$ verglichen, so daß am Ausgang ein Signal entsteht (Figur 2g), welches die bistabile Kippschaltung 1 wieder zurücksetzt. Hiermit ist der Impuls beendet, der am Ausgang 12 zur Verfügung steht (Figur 2b). Damit die Komparatorschaltung 11 nur während der Zeit bis zum Erreichen der Referenzspannung arbeitet wird sie durch den Teiler 4 über eine bistabile Kippschaltung 13 aktiviert, die durch den Ausgangsimpuls der Komparatorschaltung 11 wieder zurückgesetzt wird (Figur 2f). In Figur 2h ist gezeigt, wie durch die Einstellung der Verhältnisse der beiden Ströme I1 zu I2 die Impulsdauer T veränderbar ist. Figur 2b, f, g, h zeigt den Fall für I1=I2 (durchgezogene Linie) und für I1=0,75 I2 (gestrichelte Linie).

Für die Impulsdauer T ergibt sich rechnerisch aus den Strömen I1 und I2 sowie aus der Periodendauer t des Impulsgenerators 3: $T=(1+I2/I1)\,t$ mit den Grenzen für I2: $0{,}9\,I1 \leqslant I2 \leqslant 1{,}8\,I1$.

Ist eine längere Impulsdauer erforderlich, kann diese durch Zwischenschaltung eines Teilers zwischen Impulsgenerator 3 und Torschaltung erzeugt werden.

Fig. 2 i, k zeigt, daß die Dauer T des erzeugten Impulses von der Phasenbeziehung zwischen dem Trigger-Impuls S und dem Generator-Impuls unabhängig ist. In Fig. 2 i ist ein gegenüber Fig. 2c phasenverschobenes Generator-Signal aufgetragen. Figur 2k zeigt den zugehörigen Spannungsverlauf Uc, der die gleiche Impulsdauer T liefert.

## Patentansprüche

1. Schaltungsanordnung zur Erzeugang eines durch einen Triggerimpuls ausgelösten Impulses bestimmter Dauer mit einer ersten Konstantstromquelle, die durch eine bistabile Kippschaltung einen Kondensator lädt und mit einem Impulsgenerator, der eine zweite Konstantstromquelle zur Entladung des Kondensators einschaltet, dadurch gekennzeichnet, daß die erste Konstantstromquelle (7) bei Eintreffen des Triggerimpulses (S) durch die bistabile Kippstufe (1) den auf eine feste Referenzspannung $U_{ref}$ vorgelanenen Kondensator (8) während eines ersten Zeitabschnittes (t1—t2) auflädt, und daß der auf den Triggerimpuls (S) folgende Impuls des Impulsgenerators (3) die zweite Konstantstromquelle (10) für die Dauer (t2—t3) einer Periode des Impulsgenerators (3) einschaltet und den Kondensator (8) bis unterhalb der Referenzspannung $U_{ref}$ entlädt, und daß der nachfolgende Impuls des Impulsgenerators (3) die erste Konstantstromquelle (7) ein- und die zweite Konstantstromquelle (10) abschaltet, bis die Spannung UC am Kondensator (8) die Referenzspannung $U_{ref}$ erreicht, wobei bistabile Kippstufe (1) zurückgesetzt wird, wobei die Dauer des erzeugten Impulses durch das Verhältnis der Ströme (I1, I2) der Konstantstromquelle (7 und 10) einstellbar ist.

2. Schaltungsanordnung nach Anspruch 1, dadurch gekennzeichnet, daß die bistabile Kippschaltung (1) durch eine Komparatorschaltung (11) zurückgesetzt wird, an deren ersten Eingang (+) die Spannung UC des Kondensators (8) geschaltet ist, die mit der an ihrem zweiten Eingang (−) anliegenden Referenzspannung $U_{ref}$ verglichen wird.

3. Schaltungsanordnung nach Anspruch 1, dadurch gekennzeichnet, daß die Komparatorschaltung (11) während des Aufladens des Kondensators (8) bis zum Erreichen der Referenzspannung $U_{ref}$ aktiv geschaltet ist.

## Revendications

1. Montage destiné à générer une impulsion de durée déterminée déclenchée par une impulsion de déclenchement, comportant une première source de courant constant qui charge un condensateur à l'aide d'une bascule bistable, et un générateur d'impulsions qui connecte une deuxième source de courant constant pour décharger le condensateur, caractérisé en ce que la première source de courant constant (7) charge à l'arrivée de l'impulsion de déclenchement (S) le condensateur (8) préchargé à une tension de référence fixe $U_{ref}$ pendant une première periode (t1 à t2) à l'aide de la bascule bistable (1), et que l'impulsion du générateur d'impulsions (3) qui succède à l'impulsions de déclenchement (S), connecte la deuxième source de courant constant (10) pour la durée (t2 à t3) d'une période du générateur d'impulsions (3) et décharge le condensateur (8) jusqu'à un niveau situé au-dessous de la tension de référence $U_{ref}$, et que l'impulsion suivant fournie par la générateur d'impulsions (3) connecte la première source de courant constant (7) et déconnecte la deuxième source de courant constant (10) jusqu'à ce que la tension UC atteigne la tension de référence $U_{ref}$ au condensateur (8), la bascule bistable (1) étant remise à l'état initial, alors que la durée de l'impulsion produite est réglable par le rapport entre les courants (I1, I2) des sources de courant constant (7 et 10).

2. Montage selon la revendication 1, caractérisé en ce que la bascule bistable (1) est remise à l'état initial par un circuit comparateur (11), dont la première sortie (+) reçoit la tension UC du condensateur (8) qui est comparée à la tension de référence U disponible à sa deuxième sortie (−).

3. Montage selon la revendication 1, caractérisé en ce que le circuit comparateur (11) reste à l'état actif pendant la charge du condensateur (8) jusqu'à ce que la tension de référence U soit atteinte.

## Claims

1. A circuit arrangement for generating a pulse of specific duration which is triggered by a trigger pulse, having a first constant current source which charges a capacitor through a bistable trigger circuit, and having a pulse generator which switches on a second constant current source to discharge the capacitor, characterised in that, on arrival of the trigger pulse (S), the first constant current source, during a first period of time (t1—t2), charges, through the bistable trigger stage (1), the capacitor (8) precharged to a fixed reference voltage $U_{ref}$, and that the pulse of the pulse generator (3) following on the trigger pulse (S) switches on the second constant current source (10) for the duration (t2—t3) of one cycle of the pulse generator (3) and discharges the capacitor (8) to below the reference voltage $U_{ref}$, and that the following pulse of the pulse generator (3) switches on the first constant current source (7) and switches off the second constant current source (10) until the voltage UC at the capacitor (8) reaches the reference voltage $U_{ref}$, while the bistable trigger stage (1) is reset, the duration of the pulse generated being able to be set by the ratio of the currents (I1, I2) of the constant current sources (7 and 10).

2. A circuit arrangement according to Claim 1, characterised in that the bistable trigger circuit (1) is reset by a comparator circuit (11), to the first input (+) of which the voltage UC of the capacitor (8) is connected, which voltage is compared with the reference voltage $U_{ref}$ applied to its second input (−).

3. A circuit arrangement according to Claim 1, characterised in that the comparator circuit (11) is controlled so as to be active during the charging of the capacitor (8) until the reference voltage $U_{ref}$ is reached.

Fig. 1

a)

b)

T

c)

t

d)

e)

f)

g)

$U_c$

$U_{ref}$

h)

$t_1$ $t_2$ $t_3$ $t_4$ $t_{4'}$

i)

$\Delta$

k)

T

Fig. 2

T-PA 538

2